(19) Europäisches Patentamt / European Patent Office / Office européen des brevets

(11) **EP 2 010 853 B1**

(12) **EUROPÄISCHE PATENTSCHRIFT**

(45) Veröffentlichungstag und Bekanntmachung des Hinweises auf die Patenterteilung:
**17.02.2016 Patentblatt 2016/07**

(21) Anmeldenummer: **07724381.4**

(22) Anmeldetag: **19.04.2007**

(51) Int Cl.:
*F28D 1/06* *(2006.01)*   *F28F 3/12* *(2006.01)*
*H05K 7/20* *(2006.01)*   *H01L 23/467* *(2006.01)*

(86) Internationale Anmeldenummer:
**PCT/EP2007/003444**

(87) Internationale Veröffentlichungsnummer:
**WO 2007/121925 (01.11.2007 Gazette 2007/44)**

(54) **MEHRSTUFIGER WÄRMETAUSCHKANAL MIT PARALLEL ANGEORDNETEM LEITKANAL**

MULTISTAGE HEAT EXCHANGING DUCT COMPRISING A PARALLEL CONDUIT

CANAL D'ÉCHANGE THERMIQUE À PLUSIEURS ÉTAGES EN PARALLÈLE DUQUEL EST DISPOSÉ UN CANAL CONDUCTEUR

(84) Benannte Vertragsstaaten:
**CH FR GB LI**

(30) Priorität: **20.04.2006 DE 102006018709**
**27.07.2006 DE 102006035552**

(43) Veröffentlichungstag der Anmeldung:
**07.01.2009 Patentblatt 2009/02**

(73) Patentinhaber: **NFT Nanofiltertechnik Gesellschaft mit beschränkter Haftung**
**61348 Bad Homburg v.d.H. (DE)**

(72) Erfinder: **HOFMANN, Wilfried**
**80802 München (DE)**

(74) Vertreter: **von Bülow, Tam**
**Rotbuchenstrasse 6**
**81547 München (DE)**

(56) Entgegenhaltungen:
**EP-A- 1 727 411      US-A- 4 222 373**
**US-A- 4 257 398      US-A1- 2004 100 773**
**US-A1- 2005 286 222    US-B1- 7 167 363**

**Beschreibung**

Die Erfindung bezieht sich auf einen Wärmetauscher gemäß dem Oberbegriff des Patentanspruches 1.

Ein solcher Wärmetauscher ist beispielsweise aus der US-A-4257398 bekannt. Dort ist ein Sonnenkollektor mit einem Wärmetauscher beschrieben, der mehrere in Strömungsrichtung eines Mediums hintereinander angeordnete Stufen mit je einem Wärmetauschkanal aufweist. Die erste Stufe weist mindestens einen parallel zum Wärmetauschkanal angeordneten Leitkanal auf und der Wärmetauschkanal am Ende der jeweiligen Stufe hat mindestens einen Auslaß. Weiter steht der Leitkanal der jeweiligen Stufe mit dem Wärmetauschkanal der nächstfolgenden Stufe in Strömungsverbindung.

Die US 2005/286222 A1 zeigt eine Kühleinrichtung für elektronische Bauteile bzw. Schaltschränke mit einem Einlaß, der durch Leitbleche ein durchströmendes Medium in mehrere Teilströme aufteilt, die in Strömungsrichtung unterschiedliche Länge haben. Strömungskanäle für die einzelnen Teilströme haben jeweils einen eigenen Auslaß.

Die US 2004/100773 A1 zeigt einen Wärmetauscher für elektronische Bauteile mit mehreren parallel verlaufenden Strömungskanälen, wobei jeweils zwei benachbarte Strömungskanäle miteinander in Strömungsverbindung stehen und einlaßseitig ein Leitblech vorgesehen ist, das dafür sorgt, daß am Anfang des Strömungsweges nur ein Strömungskanal eines solchen Paares von einem Medium durchströmt wird.

Die US-A-4222373 zeigt einen modular aufgebauten Solarkollektor mit Steckverbindungen, über die einzelne Module verbindbar sind.

Die DE 10 2004 030 675 A1 bildet zur Kühlung elektronischer Bauelemente, die in einem Schaltschrank untergebracht sind, zusammen mit einer Wand des Schaltschrankes einen Kanal, der von einem Medium, wie z.B. Luft, durchströmt wird. Der Kanal hat einen Einlaß für kühle Luft und einen Auslaß für erwärmte Luft. An der Kanalwand sind Kühlelemente angebracht, die für einen besseren Wärmeübergang von der Wand an die vorbeiströmende Luft sorgen sollen.

Wärmetauscher mit hintereinander angeordneten Stufen, wobei jede Stufe jeweils mit frischem Medium beschickt wird, sind aus der US 2004/0256092 A1 und US 2002/0000311 A1 bekannt.

Allgemein ist der Wärmefluß WF einer überströmten Fläche A proportional der Temperaturdifferenz $\Delta T$ zwischen Fluid und Oberfläche und der Oberfläche A. Als Proportionalitätskonstante $\alpha$ wird der Wärmeübertragungskoeffizient in [W/m$^2$ * K] gewählt, so daß gilt:

$$WF = \alpha * A * \Delta T$$

Der Wärmeübertragungskoeffizient $\alpha$ wird durch Materialkonstanten sowie ggf. die erwähnten Kühlelemente beeinflußt, die beispielsweise für eine Verwirbelung sorgen.

Aus obiger Gleichung ist ersichtlich, daß die Kühlleistung proportional der Temperaturdifferenz $\Delta T$ ist. Je länger der Strömungsweg des Kühlfluides ist, desto mehr erwärmt es sich, so daß die Temperaturdifferenz längs des Strömungsweges abnimmt und somit auch die Kühlleistung.

Es sei darauf hingewiesen, daß analoge Verhältnisse selbstverständlich auch für Erwärmung gelten, wenn beispielsweise ein heißes Medium Wärme an einen anderen Gegenstand, wie z.B. eine Platte abgeben soll. Wenn im folgenden von Kühlung oder Kühlleistung gesprochen wird, so gilt dies analog selbstverständlich auch für Heizung bzw. Heizleistung.

Wie bei dem eingangs genannten Stand der Technik gezeigt, sind oftmals langgestreckte Flächen zu kühlen bzw. zu erwärmen, wobei sich das Problem der abnehmenden Kühlleistung mit zunehmender Länge stellt.

Eine Möglichkeit zur Lösung des Problems liegt darin, die Strömungsgeschwindigkeit des Fluides und damit den Volumenstrom des Fluides zu erhöhen. Dies bedingt aber größer dimensionierte Fördereinrichtungen für das Fluid, also beispielsweise größer dimensionierte Gebläse, was wiederum höhere Antriebsleistungen und damit meist höheren Stromverbrauch bedingt sowie einen vergrößerten Platzbedarf und schließlich auch eine höhere Geräuschentwicklung.

Aufgabe der Erfindung ist es daher, den Wärmetauscher der eingangs genannten Art dahingehend zu verbessern, daß er auch bei größeren zu kühlenden oder zu erwärmenden Flächen eine gute Leistung bringt und gleichzeitig geringen Platzbedarf erfordert.

Diese Aufgabe wird durch die im Patentanspruch 1 angegebenen Merkmale gelöst. Vorteilhafte Ausgestaltungen und Weiterbildungen der Erfindung sind den Unteransprüchen zu entnehmen. Das Grundprinzip der Erfindung liegt darin, den Wärmetauscher aus mindestens zwei oder mehreren hintereinander angeordneten Stufen zu realisieren, wobei jeder Stufe "frisches" Medium zugeführt wird, während das "verbrauchte" Medium am Ende der Stufe abgeführt wird.

Jede der Stufen, mit Ausnahme der letzten, hat somit einen Wärmetauschkanal und einen dazu parallel verlaufenden Leitkanal für "frisches" Fluid, das in der entsprechenden Stufe nicht am Wärmetausch teilnimmt. Am Ende jeder Stufe wird das Fluid des Wärmetauschkanales durch Auslaßöffnungen abgeführt und "frisches" Fluid des Leitkanales dem Wärmetauschkanal der nächsten Stufe zugeführt sowie ggf. einem weiteren Leitkanal der nächsten Stufe. Quer zur Strömungsrichtung des Fluides gesehen kreuzen sich somit die Fluidströmungen von verbrauchtem und frischem Fluid, wobei selbstverständlich durch hier "Kreuzstromelemente" genannte Führungskanäle diese beiden Strömungen getrennt sind.

Die einzelnen Stufen können modular aufgebaut sein, so daß theoretisch beliebig viele Elemente hintereinander angeordnet werden können.

Vorzugsweise liegen alle Wärmetauschkanäle der einzelnen Stufen in einer Ebene, so daß sich ein einfacher geometrischer Aufbau ergibt, bei dem der Wärmetauschkanal und der Leitkanal jeweils quaderförmig sind. Diese Kanäle haben auch einen geringen Strömungswiderstand, so daß auch mit klein dimensionierten Fördereinrichtungen, wie z.B. Gebläsen, beachtliche Volumenströme und damit auch Wärmeströme realisiert werden können. Nach einer Weiterbildung der Erfindung ist der Auslaß des Wärmetauschkanals der jeweiligen Stufe so ausgestalltet, daß mindestens ein Leitbleich das Fluid in Richtung zu mindestens einer Seitenwand des Wärmeleitkanals umlenkt, wobei die entsprechende Seitenwand dort eine Auslaßöffnung aufweist. Vorzugsweise sind an den beiden Seitenwänden des jeweiligen Wärmetauschkanales solche Auslaßöffnungen vorhanden, wobei nach einer vorteilhaften Ausgestalltung der Erfindung die Summe der Querschnitte der Auslaßöffnungen dem Querschnitt des Wärmetauschkanals entspricht.

Der Wärmetauscher nach der Erfindung hat auch einen geringen Platzbedarf, insbesondere durch seine geringe Höhe in der Ebene senkrecht zur Strömungsrichtung und erlaubt daher auch die Verwendung auf beiden Seiten einer Oberfläche, wie z.B. einer zu kühlenden Wand eines Schaltschrankes. Gleichwohl hat der Wärmetauscher nach der Erfindung nur einen Fluideinlaß. Das anströmende Fluid wird somit in jeder Stufe in mindestens zwei Teilströme aufgeteilt, die jeweils verschiedenen Kanälen zugeführt werden. Nach thermischer Wechselwirkung zwischen dem Fluid und einer Oberfläche, die zu kühlen oder zu erwärmen ist, wird dieses Fluid abgeführt, ohne mit anderen Teilströmen des Fluids in Wechselwirkung zu treten.

Die thermische Wechselwirkung zwischen Fluid und Oberfläche findet jeweils an den separat angeströmten Abschnitten der Oberfläche im Wärmetauschkanal statt, wobei vorzugsweise Maßnahmen zur Verbesserung der Wärmeübertragung eingesetzt werden, wie z.B. aufgerauhte Oberflächen, Kühlrippen oder Mikrorippen gemäß DE 102 33 736 B3 oder ähnliches.

Die genannten Kreuzstromelemente haben die Funktion, das Fluid den entsprechenden Oberflächenabschnitten des Wärmetauschkanales bzw. des Leitkanales zuzuleiten bzw. von diesen abzuleiten.

Im folgenden wird die Erfindung anhand eines Ausführungsbeispieles im Zusammenhang mit der Zeichnung ausführlicher erläutert. Es zeigt:

Fig. 1    einen schematischen Querschnitt eines dreistufigen Wärmetauschers nach einem Ausführungsbeispiel der Erfindung;

Fig. 2    eine schematische Draufsicht des Wärmetauschers der Fig. 1;

Fig. 3    eine perspektivische Ansicht schräg von oben auf den Wärmetauscher der Figuren 1 und 2;

Fig. 4    eine schematische Seitenansicht eines Wärmetauschers ähnlich Fig. 1, jedoch nach einer anderen Variante der Erfindung.

Fig. 5    eine perspektivische, geschnittene Ansicht schräg von oben eines Wärmetauschers nach einem weiteren Ausführungsbeispiel der Erfindung;

Fig. 6    eine perspektivische Ansicht schräg von unten auf den Wärmetauscher der Fig. 5; und

Fig. 7    eine Ansicht der Unterseite des Wärmetauscher der Figuren 5 und 6.

Gleiche Bezugszeichen in den einzelnen Figuren bezeichnen gleiche bzw. funktionell einander entsprechende Teile. Weiter sei darauf hingewiesen, daß die Beschreibung eines dreistufigen Wärmetauschers nicht beschränkend ist. Es müssen lediglich mindestens zwei Stufen vorhanden sein, während nach oben keine Begrenzung besteht.

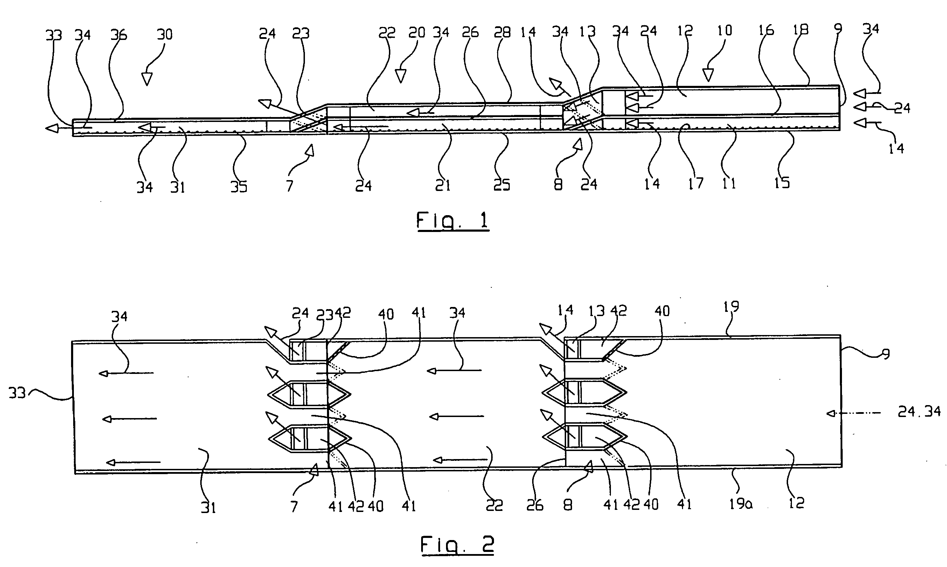

Fig. 1 zeigt eine schematische Seitenansicht des Wärmetauschers, der hier drei Stufen 10, 20 und 30 hat. Die erste Stufe 10 hat einen Wärmetauschkanal 11, durch den ein Fluid, wie z.B. Luft, fließen kann, und zwar mit einem ersten Teilstrom 14, der durch einen Pfeil angedeutet ist. Der Wärmetauschkanal 11 hat eine Wärmeübertragungswand 15, die mit dem Teilstrom 14 in wärmeübertragender Wechselwirkung steht, wobei diese Wand 15 noch Mittel an ihrer Innenseite aufweisen kann, die die Wärmeübertragung verbessern, wie z.B. Kühlrippen, Aufrauhungen oder Mikrorippen gemäß DE 102 33 736 B3.

Der Wärmetauschkanal 11 hat weiterhin eine Trennwand 16, die den Wärmetauschkanal 11 von einem darüberliegenden Leitkanal 12 abtrennt. Der Leitkanal 12 ist durch eine Deckwand 18 abgeschlossen. Die beiden Kanäle 11 und 12 sind seitlich durch gemeinsame Seitenwände 19 und 19a (vgl. Fig. 2) abgeschlossen. Beide Kanäle haben einen gemeinsamen Einlaß 9 für Fluid, das bereits am Einlaß 9 durch die Trennwand 16 in Teilströme aufgeteilt wird, nämlich den ersten Teilstrom 14, der durch den Wärmetauschkanal 11 fließt, und mindestens einen weiteren Teilstrom 24 und/oder 34, der durch den Leitkanal 12 fließt und somit nicht in wärmetauschender Wechselwirkung mit dem Wärmetauschkanal 11 bzw. der Warmeübertragungswand 15 steht.

Am strömungsabwärtigen Ende der ersten Stufe 10 ist ein "Kreuzstromelement" 8 angeordnet, welches mit Leitblechen einerseits den Wärmetauschkanal 11 mit einem Auslaß 13 verbindet, über den der erste Teilstrom 14 zur Athmosphäre nach außen hin abgeführt werden kann und andererseits den Leitkanal 12 mit der zweiten Stufe 20 verbindet, so daß die Teilströme 24 und 34 der zweiten Stufe 20 zugeleitet werden. Die Teilströme 14 einerseits und 24 und 34 andererseits sind durch die Leitbleche voneinander getrennt und stehen in keiner wärmetauschenden Wechselwirkung miteinander.

Da der erste Teilstrom 14 in dem Wärmetauschkanal 11 in wärmetauschender Wechselwirkung stand, ist dessen Medium "verbraucht" und hat gegenüber der Wärmeübertragungswand 15 nur noch einen geringen Temperaturunterschied ΔT, während die Teilströme 24 und 34 noch "unverbrauchtes" Medium mit sich führen, das noch eine relativ große Temperaturdifferenz ΔT in Bezug auf die nächst folgenden Stufen 20 und 30 hat.

In Bezug auf die Darstellung der Fig. 1 wird also der erste Teilstrom 14 über die Öffnung des Auslasses 13 nach oben abgeleitet, während die Teilströme 24 und 34 schräg nach unten geleitet werden, wo sie in der zweiten Stufe 20 durch eine dortige Trennwand 26 aufgeteilt werden. Die zweite Stufe 20 hat in analoger Weise einen Wärmetauschkanal 21 und einen Leitkanal 22. Der Teilstrom 24 fließt durch den Wärmetauschkanal 21 und steht dort in wärmetauschender Wechselwirkung mit einer Wand 25, während im Leitkanal 22 der Teilstrom 34 in keiner wärmetauschenden Wechselwirkung mit der Wand 25 steht.

In analoger Weise ist am Ende der zweiten Stufe 20 wiederum ein Kreuzstromelement 7 angebracht, das über Leitbleche wiederum den Wärmetauschkanal 21 mit einer Öffnung 23 verbindet und den Leitkanal 22 mit einem Wärmetauschkanal 31 der dritten Stufe 30, die hier die letzte Stufe ist und daher keinen Leitkanal mehr benötigt, sondern nur noch eine Deckwand 36 und hier eine wärmetauschende Wand 35 hat. Am Auslaß 33 der dritten Stufe fließt dann das dort verbrauchte Medium mit dem Teilstrom 34 ab.

In Fig. 2 sind jeweils die Deckwände 18, 28 und 36 fortgelassen, so daß man bei den beiden ersten Stufen 10 und 20 in das Innere der Leitkanäle 12 und 22 und bei der dritten Stufe 30 in das Innere des Wärmetauschkanales 31 sieht. Man erkennt die Kreuzstromelemente 7 und 8, die in der jeweils oberen Ebene der Leitkanäle 12 und 22 Leitbleche 40 haben, die in Überleitkanäle 41 münden, wobei diese Überleitkanäle, wie aus Fig. 1 zu erkennen ist, schräg nach unten geneigt sind. Im Übergangsbereich zwischen der ersten Stufe 10 und der zweiten Stufe 20 erkennt man auch die Trennwand 26, an der die Teilströme 24 und 34 getrennt werden.

Weiter sind Leitbleche in gestrichelten Linien dargestellt. Es handelt sich dabei um Leitbleche der untersten Ebene der jeweiligen Wärmetauschkanäle, die die Fluidteilströme in aufwärts gerichtete Ableitkanäle 42 leiten, die zu den Auslässen 13 bzw. 23 führen.

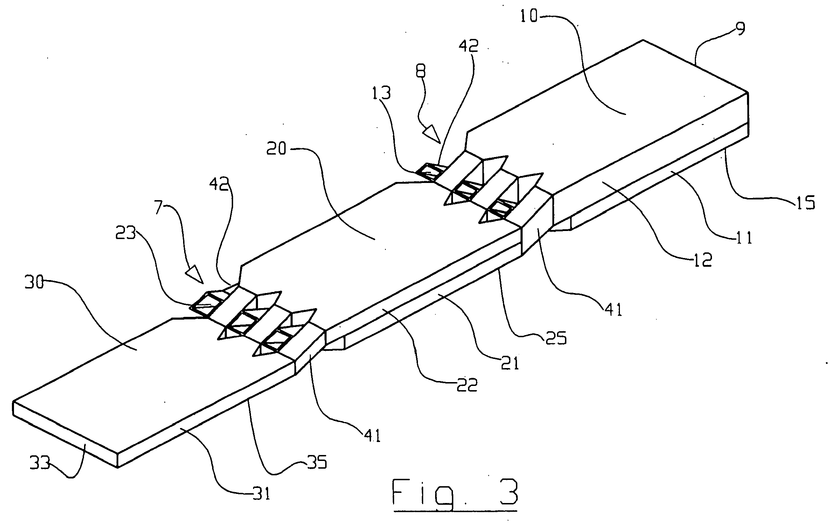

Fig. 3 zeigt den Wärmetauscher der Fig. 1 und 2 in perspektivischer Ansicht schräg von vorne in geschlossener Stellung. Die einzelnen oben beschriebenen Kanäle sind hier gut zu erkennen.

In Fig. 1 sind die Wärmeübertragungswände 15, 25 und 35 als einstückig durchgehend dargestellt. Es ist aber auch möglich, wie in Fig. 3 dargestellt, diese Wände jeweils einzeln zu gestalten, so daß die Verbindung zwischen aufeinanderfolgenden Stufen jeweils nur über die Kreuzstromelemente 7 und 8 erfolgt.

Im Ausführungsbeispiel der Fig. 1 bis 3 hat der Wärmetauscher einen einzigen Einlaß 9 für das Fluid, jedoch drei in Strömungsrichtung hintereinander liegende Auslässe 13, 23 und 33 für die Teilströme 14, 24 und 34.

Für manche Anwendungsfälle ist es jedoch zweckmäßig, lediglich einen Einlaß und einen Auslaß zu haben.

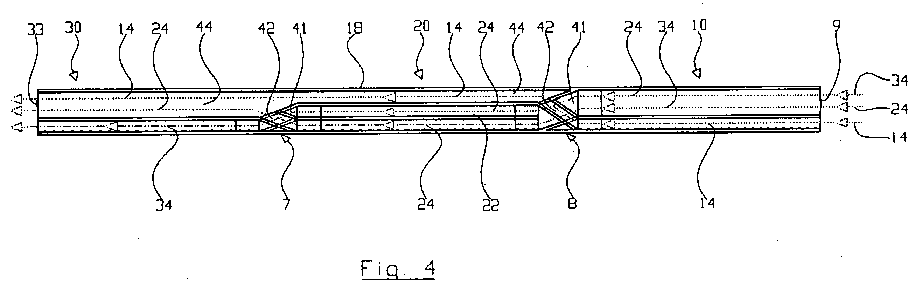

Zu diesem Zweck ist bei der Variante der Fig. 4 die Deckwand 18 der ersten Stufe 10 über den gesamten Wärmetauscher hinweg verlängert, so daß sich für die zweite Stufe 20 oberhalb deren Leitkanal 22 noch ein weiterer Leitkanal 44 ergibt, in welchem der Teilstrom 14 abgeleitet wird, und sich am Ende der zweiten Stufe mit dem Teilstrom 24 vereinigt, so daß insgesamt nur ein Auslaß 33 vorhanden ist. Es ist klar, daß die Auslässe 13 und 23 des Ausführungsbeispieles der Fig. 1 in diesem Ausführungsbeispiel in den Leitkanal 44 münden.

Der Wärmetauscher nach der Erfindung besteht aus wenigen einfachen Grundelementen, die bausatzartig kombiniert werden können, um die Kapazität der Wärmeleistung an den jeweiligen Anwendungsfall anzupassen. Die einzelnen Stufen samt stromabwärtigem Kreuzstromelement können als Modul aufgebaut sein, wobei dann Module für eine erste, zweite, dritte, vierte usw. Stufen hergestellt werden, die vorzugsweise über Steckverbindungen miteinander gekoppelt werden, wobei dann lediglich die einzelnen Stufen zusammengesteckt und ggf. noch zusätzlich verbunden werden, wie z.B. durch Kleben, Löten, Schweißen oder sonstige bekannte Verbindungsarten. Die einzelnen Grundelemente bestehen aus dünnen Platten, die aus Metall oder Kunststoff bestehen können und die ineinander gesteckt und/oder miteinander verklebt werden können. Der Wärmetauscher hat daher auch ein geringes Gewicht und kann ohne besonderen Aufwand mit einer zu kühlenden oder zu erwärmenden Oberfläche verbunden werden.

Generell ist es auch möglich, die Wärmeübertragungswand 15, 25 und 35 fortzulassen, so daß eine zu kühlende oder zu erwärmende Fläche eines Gegenstandes die Unterseite des jeweiligen Wärmetauschkanales bildet. Selbstverständlich ist die Wärmeübertragungswand 15, 25 und 35 aus gut wärmeleitenden Material.

Je nach Anwendungsfall können die einzelnen Stufen 10, 20 bzw. 30 auch gebogen sein, um sich so an die Kontur eines zu kühlenden oder zu erwärmenden Gegenstandes anzupassen.

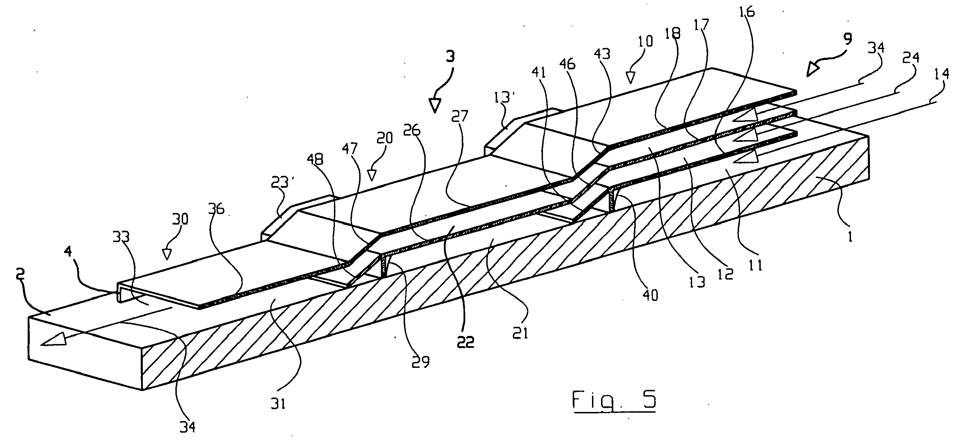

Die Figuren 5-7 zeigen ein zweites Ausführungsbeispiel.

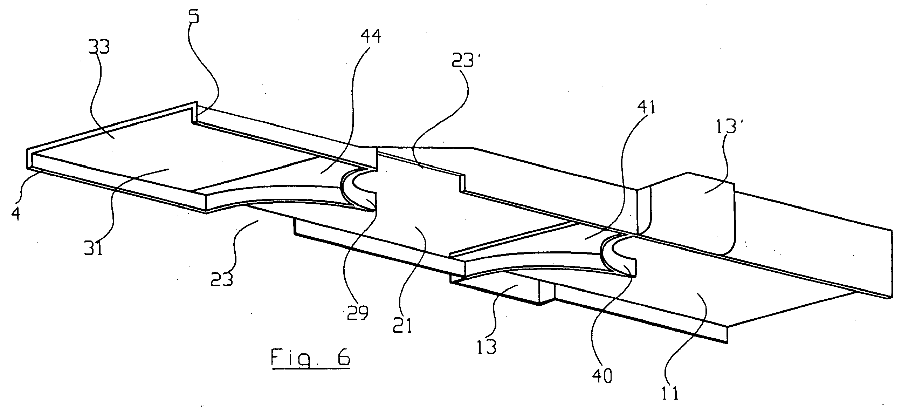

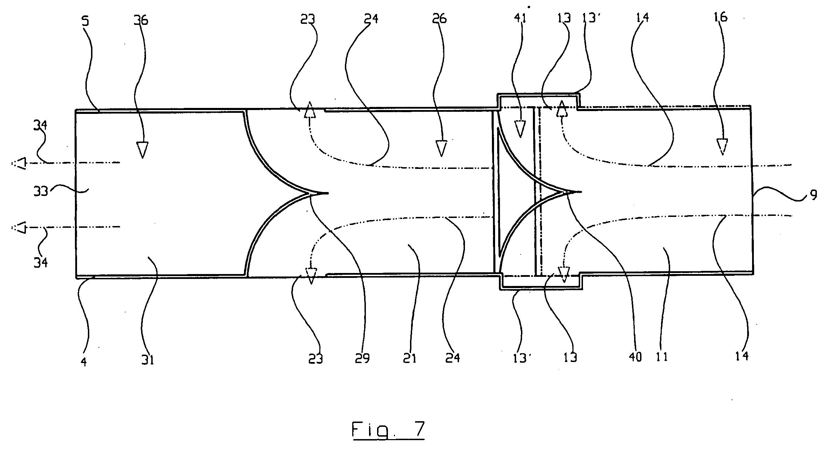

Fig. 5 zeigt einen zu kühlenden oder zu erwärmenden Gegenstand 1 mit einer ebenen Oberfläche 2, auf den der Wärmetauscher 3 aufgesetzt ist. Der Wärmetauscher 3 hat hier ebenfalls drei Stufen 10, 20 und 30, die in Strömungsrichtung eines wärmeübertragenden Mediums, wie z.B. Luft, hintereinander angeordnet sind. Jede der drei Stufen 10, 20 und 30 hat einen Wärmetauschkanal 11, 21 bzw. 31, der hier einerseits jeweils durch die ebene Oberfläche 2 des Gegenstandes 1, durch Seitenwände 4 und 5 (Fig. 6 und 7) und je eine Trennwand 16, 26 bzw. 36 begrenzt ist, wobei die Trennwand 36 der letzten Stufe 30 die Funktion einer Deckwand hat.

Der Wärmetauscher 3 ist so aufgebaut, daß das der jeweiligen Stufe 10, 20 bzw. 30 und damit den jeweiligen Wärmetauscherkanälen 11, 21 und 31 zugeführte Medium "frisches" und noch nicht "verbrauchtes" Medium ist, das vor Erreichen des jeweiligen Wärmetauschkanales noch an keinem Wärmetauschvorgang in einer vorhergehenden Stufe teilgenommen hat.

Der Wärmetauscher 3 hat einen gemeinsamen Einlaß 9 für das Medium, das bei dem hier gezeigten dreistufigen Wärmetauscher in drei Teilströme 14, 24 und 34 aufgeteilt wird, indem parallel zur Trennwand 16 des ersten Wärmetauschkanales 11 zwei weitere Wände 17 und 18 angeordnet sind, die zusammen mit den Seitenwänden 4 und 5 Leitkanäle 12 und 13 für die Teilströme 24 und 34 bilden, durch welche das Medium hindurchströmt, ohne an einem Wärmetauschervorgang des ersten Wärmetauschkanales 11 teilzunehmen.

Im ersten Wärmetauschkanal 11 ist ein Leitblech 40 angeordnet, das, wie am besten aus Fig. 7 zu erkennen ist, mit zwei bogenförmigen Schenkeln die in Strömungsrichtung hintere Seite des Wärmetauschkanales 11 begrenzt und den Teilstrom 14 zu Öffnungen 13 in den Seitenwänden 4 und 5 ableitet. Damit wird am stromabwärtigen Ende des ersten Wärmetauschkanales 11 das bis dahin verbrauchte Medium seitlich abgeführt, wobei durch kaminartige seitliche Ansätze 13' die Strömung auch nach oben, also senkrecht zur ebenen Oberfläche 2 umgeleitet werden kann, oder auch schräg nach oben. Die Querschnittsfläche der beiden seitlichen Öffnungen 13 entspricht im wesentlichen der Querschnittsfläche des Wärmetauschkanales 11, so daß das Medium mit dem Teilstrom 14 (Fig. 7) im wesentlichen unbehindert abfließen kann und somit der Strömungswiderstand sehr gering ist.

Der Leitkanal 12 der ersten Stufe steht mit dem Wärmetauschkanal 21 der zweiten Stufe 20 in Strömungsverbindung, indem die obere Wand 17 des Leitkanales 12 über eine schräge Wand 46 mit der Trennwand 26 des zweiten Wärmetauschkanales 21 verbunden ist. Damit strömt das unverbrauchte Medium mit dem Teilstrom 24 in die zweite Stufe 20 und nimmt dort am Wärmetausch teil. Die zweite Stufe 20 ist in gleicher Weise durch ein identisches Leitblech 29, das zu seitlichen Öffnungen 23 in den Wänden 4 und 5 führt, abgeschlossen, so daß am stromabwärtigen Ende der zweiten Stufe der Teilstrom 24 durch diese Öffnungen 23 abströmen kann, wobei auch hier die Summe der Querschnittsflächen der Öffnungen 25 der Querschnittsfläche des zweiten Wärmetauschkanales 21 entspricht.

Oberhalb des zweiten Wärmetauschkanales 21 ist wiederum ein Leitkanal 22 vorgesehen, der zwischen der Trennwand 26 und einer Deckwand 27 gebildet ist, die parallel zur Trennwand 26 verläuft. Die Deckwand 27 ist über eine schräg verlaufende Wand 43 mit der Wand 18 verbunden, so daß der Teilstrom 34 aus der ersten Stufe 10 und dem dortigen Leitkanal 13 in den Leitkanal 23 der zweiten Stufe 20 fließt und von dort wiederum über eine schräge Wand 47 in die dritte Stufe 30, die durch die Deckwand 36 und die beiden Seitenwände 4 und 5 gebildet wird. Am Ende der dritten Stufe 30 sind keine Leitbleche analog den Leitblechen 40 und 29 vorhanden. Vielmehr strömt das Medium mit dem Teilstrom 34 am stromabwärtigen Ende des dritten Wärmetauschkanales 31 durch eine Öffnung 33 ab. Will man die Abluft generell in der gleichen Richtung haben, so kann allerdings auch dort in analoger Weise ein Leitblech vorgesehen sein sowie seitliche Öffnungen analog den Öffnungen 15 und 25.

In Fig. 5 ist noch dargestellt, daß im Übergangsbereich vom vorhergehenden Leitkanal zu dem jeweiligen Wärmetauschkanal 21 bzw. 31 noch weitere Leitbleche 41 und 48 vorgesehen sind, die parallel zu den schrägen Blechen 43, 46 bzw. 47 verlaufen. Hierdurch wird eine gleichmäßige Strömung erreicht, und Verwirbelungen an der Leeseite der Leitbleche 40 bzw. 29 werden vermieden. Es sei darauf hingewiesen, daß diese Bleche 41 und 48 auch fortgelassen werden können, so daß das jeweilige Medium direkt stromabwärts der Leitbleche 40 und 29 in den Wärmeleitkanal der nächstfolgenden Stufe gelangen kann. Die Deckwände 16 und 26 enden dann stromabwärts jeweils schon an den Leitblechen 40 bzw. 29.

Wie am besten aus Fig. 7 zu erkennen, können die Teilströme 14 und 24 verbrauchten Mediums am stromabwärtigen Ende des jeweiligen Wärmetauschkanales entweder seitlich durch die Wände 4 und 5 parallel zur Oberfläche 2 (Fig. 5) des zu kühlenden Gegenstandes abgeführt werden, wie an den Öffnungen 23 in Fig. 7 dargestellt, oder sie können durch Leitkamine 13', die seitlich an die Öffnungen 13 angesetzt sind, umgeleitet werden, so daß das Medium senkrecht zur Oberfläche 2 abströmt.

Weiter sei darauf hingewiesen, daß die Form der Leitbleche 40 und 29 abgewandelt werden kann. Die bevorzugte Variante ist die Kreisbogenform, die am besten aus Fig. 7 zu erkennen ist mit zwei Kreisbögen, die in der Mitte des jeweiligen Wärmeleitkanales eine stromteilende Spitze bilden. Es können aber auch geradlinige, V-förmige Leitkanäle verwendet werden, die symmetrisch oder asymmetrisch angeordnet sind. Falls für bestimmte Anwendungsfälle eine Ableitung verbrauchten Mediums nur zu einer Seite hin gewünscht wird, kann auch nur eine seitliche Öffnung in einer der beiden Seitenwände 4 und 5 vorgesehen sein, wobei dann das entsprechende Leitblech schräg durch den gesamten Wärmetauschkanal verläuft. Weiter ist in Fig. 7 die Variante gezeigt, bei der das schräge Blech 48 der Fig. 5 fortgelassen ist, so daß das Medium von dem Leitkanal 23 auf der stromabwärtigen Seite des Leitbleches 29 direkt in den dritten Wärmetauschkanal gelangt.

Das Ausführungsbeispiel der Fig. 6 zeigt in perspektivischer Ansicht schräg von unten den Wärmetauscher nach der Erfindung, wobei hier beide seitliche Öffnungen 13 und 23 in die kaminartigen Ansätze 13' und 23' münden.

**Patentansprüche**

1. Wärmetauscher mit einem Wärmetauschkanal (11, 21, 31), der einen Einlaß (9) und einen Auslaß (33) für ein den Wärmetauschkanal durchströmendes Medium aufweist, wobei der Wärmetauscher mindestens zwei in Strömungsrichtung des Mediums hintereinander angeordnete Stufen (10, 20, 30) mit je einem Wärmetauschkanal (11, 21, 31) aufweist, wobei die erste Stufe (10) mindestens einen parallel zum Wärmetauschkanal (11) angeordneten Leitkanal (12) aufweist, und der Wärmetauschkanal (11, 21) am Ende der jeweiligen Stufe (10, 20) mindestens einen Auslaß hat (13, 23), und wobei der Leitkanal (12, 22) der jeweiligen Stufe (10, 20) in Strömungsverbindung mit dem Wärmetauschkanal (21, 31) der nächst folgenden Stufe (20, 30) steht, **dadurch gekennzeichnet, daß** die einzelnen Stufen (10, 20, 30) durch Kreuzstromelemente (7, 8) so miteinander verbunden sind, daß getrennte Teilströme (14, 24, 34) des Mediums vorhanden sind.

2. Wärmetauscher nach Anspruch 1, **dadurch gekennzeichnet, daß** die Stufen (10, 20, 30) durch Steckverbindungen miteinander verbunden sind.

3. Wärmetauscher nach einem der Ansprüche 1 oder 2, **dadurch gekennzeichnet, daß** die Wärmetauschkanäle (11, 21, 31) und die Leitkanäle (12, 22, 32) quaderförmig ausgebildet sind.

4. Wärmetauscher nach einem der Ansprüche 1 oder 3, **dadurch gekennzeichnet, daß** die einzelnen Stufen (10, 20, 30) miteinander verklebt sind.

5. Wärmetauscher nach einem der Ansprüche 1 bis 4, **dadurch gekennzeichnet, daß** der Wärmetauscher aus Kunststoff oder Metall aufgebaut ist.

6. Wärmetauscher nach einem der Ansprüche 1 bis 5, **dadurch gekennzeichnet, daß** der Wärmetauscher mehr als zwei Stufen (10, 20, 30) aufweist.

7. Wärmetauscher nach Anspruch 6, **dadurch gekennzeichnet, daß** die einzelnen Stufen (10, 20, 30) modular aufgebaut sind.

8. Wärmetauscher nach einem der Ansprüche 1 bis 7, **dadurch gekennzeichnet, daß** der Wärmetauscher eine alle Stufen (10, 20, 30) überdeckende Deckwand (18) aufweist, die einen weiteren Leitkanal (44) bildet, und daß die Auslässe (13, 23) aller Stufen (10, 20) mit Ausnahme der letzten Stufe (30) in diesen Leitkanal (44) münden.

9. Wärmetauscher nach Anspruch 1, **dadurch gekennzeichnet, daß** mindestens ein Wärmetauschkanal (11, 21) an seinem stromabwärtigen Ende ein Leitblech (40, 29) aufweist zur Ableitung des Mediums durch eine Öffnung (13, 23) in mindestens einer Seitenwand (4, 5) des jeweiligen Wärmeleitkanales (11, 21).

10. Wärmetauscher nach Anspruch 9, **dadurch gekennzeichnet, daß** die Querschnittsfläche der Öffnung bzw. Öffnungen (13; 23) der Querschnittsfläche des zugeordneten Leitkanales (11, 21) entspricht.

11. Wärmetauscher nach Anspruch 9 oder 10, **dadurch gekennzeichnet, daß** das Leitblech (40, 29) zwei spitz aufeinanderzuweisende Schenkel aufweist.

12. Wärmetauscher nach Anspruch 11, **dadurch gekennzeichnet, daß** die Schenkel des Leitbleches (40, 29) bogenförmig gekrümmt sind.

13. Wärmetauscher nach einem der Ansprüche 9 bis 13, **dadurch gekennzeichnet, daß** das Leitblech (40, 29) in Draufsicht spiegelsymmetrisch zur Mitte des Wärmeleitkanales (11, 21) ist.

14. Wärmetauscher nach einem der Ansprüche 9 bis 13, **dadurch gekennzeichnet, daß** an die Öffnung (13, 23) ein kaminartiger Ansatz (13', 23') angeschlossen ist, welcher durch die Öffnung (13, 23) austretendes Medium derart umlenkt, daß es mindestens eine Bewegungskomponente senkrecht zur Hauptströmungsrichtung durch den Wärmetauscher und senkrecht zur Austrittsrichtung aus der Öffnung (13, 23) aufweist.

**Claims**

1. Heat exchanger comprising a heat exchanging channel (11, 21, 31) having an inlet (9) and an outlet (33) for a medium flowing through the heat exchanging channel, wherein the heat exchanger comprises at least two stages (10, 20, 30) arranged in the flowing direction of the medium after one another, each having a heat exchanging channel (11, 21, 31),

wherein the first stage (10) comprises at least one guiding channel (12) arranged parallel to the heat exchanging channel (11), and

the heat exchanging channel (11, 21) has at least one outlet (13, 23) at the end of the respective stage (10, 20), and

wherein the guiding channel (12, 22) of the respective stage (10, 20) is in flow connection with the heat exchanging channel (21, 31) of the next following stage (20, 30),

**characterized in that** the individual stages (10, 20, 30) are connected by cross-flow elements (7, 8) in such manner that separated part flows (14, 24, 34) of the medium are present.

2. Heat exchanger according to claim 1, **characterized in that** the stages (10, 20, 30) are connected with each other by plug connections.

3. Heat exchanger according to one of claims 1 or 2, **characterized in that** the heat exchanging channels (11, 21, 31) and the guiding channels (12, 22, 32) are designed in the form of a cuboid.

4. Heat exchanger according to one of claims 1 or 3, **characterized in that** the individual stages (10, 20, 30) are glued with each other.

5. Heat exchanger according to one of claims 1 to 4, **characterized in that** the heat exchanger is manufactured from plastics or metal.

6. Heat exchanger according to one of claims 1 to 5, **characterized in that** the heat exchanger comprises more than two stages (10, 20, 30).

7. Heat exchanger according to claim 6, **characterized in that** the individual stages (10, 20, 30) are designed in a modular manner.

8. Heat exchanger according to one of claims 1 to 7, **characterized in that** the heat exchanger comprises a top wall (18) covering all stages (10, 20, 30), which forms an additional guiding channel (44) and **in that** the outlets (13, 23) of all stages (10, 20) with the exception of the last stage (30) run into said guiding channel (44).

9. Heat exchanger according to claim 1, **characterized in that** at least one heat exchanging channel (11, 21) has at its downstream end a guiding plate (40, 29) for discharging the medium through an opening (13, 23), which is provided within a side wall (4, 5) of the respective heat guiding channel (11, 21).

10. Heat exchanger according to claim 9, **characterized in that** the cross-section area of the opening or the openings (13, 23) corresponds with the cross-section area of the assigned guiding channel (11, 21).

11. Heat exchanger according to claims 9 or 10, **characterized in that** the guiding plate (40, 29) comprises two brackets, which are directed to each other in an acute manner.

12. Heat exchanger according to claim 11, **characterized in that** the brackets of the guiding plates (40, 29) are bent in a curved manner.

13. Heat exchanger according to one of claims 9 to 12, **characterized in that** the guiding plate (40, 29) is arranged in a top view mirror-symmetrically to the middle of the heat guiding channel (11, 21).

14. Heat exchanger according to one of claims 9 to 13, **characterized in that** a chimney-like projection (13', 23') is connected to the opening (13, 23), which projection is deflecting the medium discharged from the opening (13, 23) in such a way that it comprises at least a flowing component vertically to the main flowing direction through the heat exchanger and vertically to the exit direction from the opening (13, 23).

**Revendications**

1. Échangeur de chaleur avec un canal d'échange de chaleur (11, 21, 31) qui comprend une entrée (9) et une sortie (33) pour un médium qui s'écoule à travers le canal d'échange de chaleur, dans lequel l'échangeur de chaleur comprend au moins deux étages (10, 20, 30) disposés séquentiellement dans le sens d'écoulement du médium et ayant chacun un canal d'échange de chaleur (11, 21, 31),

dans lequel le premier étage (10) comprend au moins un canal de guidage (12) disposé parallèlement au canal d'échange de chaleur (11), et

le canal d'échange de chaleur (11, 21) a au moins une sortie (13, 23) à l'extrémité de l'étage correspondant (10, 20), et

dans lequel le canal de guidage (12, 22) de chaque étage (10, 20) est raccordé pour l'écoulement du flux avec le canal d'échange de chaleur (21, 31) de l'étage suivant (20, 30), **caractérisé en ce que** les étages adjacents (10, 20, 30) sont raccordés l'un à l'autre par un élément de croisement de flux (7, 8) de façon à conduire des flux partiels séparés (14, 24, 34) du médium.

2. Échangeur de chaleur selon la revendication 1, **caractérisé en ce que** les étages (10, 20, 30) sont reliés les uns aux autres par des raccords de liaison.

3. Échangeur de chaleur selon l'une des revendications 1 ou 2, **caractérisé en ce que** les canaux d'échange de chaleur (11, 21, 31) et les canaux de guidage (12, 22, 32) sont réalisés en forme de parallélépipède.

4. Échangeur de chaleur selon l'une des revendications 1 ou 3, **caractérisé en ce que** les étages adjacents (10, 20, 30) sont collés l'un à l'autre.

5. Échangeur de chaleur selon l'une des revendications 1 à 4, **caractérisé en ce que** l'échangeur de chaleur est fabriqué en matière plastique ou en métal.

6. Échangeur de chaleur selon l'une des revendications 1 à 5, **caractérisé en ce que** l'échangeur de chaleur comprend au moins deux étages (10, 20, 30).

7. Échangeur de chaleur selon la revendication 6, **caractérisé en ce que** les étages adjacents (10, 20, 30) sont construits de façon modulaire.

8. Échangeur de chaleur selon l'une des revendications 1 à 7, **caractérisé en ce que** l'échangeur de chaleur comprend une paroi supérieure (18) couvrant tous les étages (10, 20, 30), laquelle forme un canal de guidage additionnel (44), et **en ce que** les sorties (13, 23) de tous les étages (10, 20) à l'exception du dernier étage (30) communiquent avec ce canal (44).

9. Échangeur de chaleur selon la revendication 1, **caractérisé en ce que** au moins un canal d'échange de chaleur (11, 21) comprend, à son extrémité aval dans le sens d'écoulement du flux, une plaque de guidage (40, 29) pour décharger le médium à travers une ouverture (13, 23) dans au moins une paroi latérale (4, 5) du canal d'échange de chaleur respectif (11, 21).

10. Échangeur de chaleur selon la revendication 9, **caractérisé en ce que** la section transversale de la ou des ouvertures (13 ; 23) correspond avec la section transversale du canal d'échange de chaleur (11, 21) correspondant.

11. Échangeur de chaleur selon l'une des revendications 9 ou 10, **caractérisé en ce que** la plaque de guidage (40, 29) comprend deux branches qui sont dirigées en pointe l'une vers l'autre.

12. Échangeur de chaleur selon la revendication 11, **caractérisé en ce que** les branches de la plaque de guidage (40, 29) sont pliées en forme incurvée.

13. Échangeur de chaleur selon l'une des revendications 9 à 12, **caractérisé en ce que** la plaque de guidage (40, 29) est disposée en symétrie miroir en vue de dessus selon le milieu du canal d'échange de chaleur (11, 21).

14. Échangeur de chaleur selon l'une des revendications 9 à 13, **caractérisé en ce que** une excroissance en forme de cheminée (13', 23') est connectée à l'ouverture (13, 23), laquelle excroissance est disposée pour défléchir le médium sortant de l'ouverture (13, 23) de façon qu'il y ait au moins une composante d'écoulement perpendiculaire à la direction d'écoulement principal à travers l'échangeur de chaleur et perpendiculaire à la direction de sortie à travers l'ouverture (13, 23).

Fig. 1

Fig. 2

Fig. 3

EP 2 010 853 B1

Fig. 4

Fig. 5

Fig. 6

Fig. 7

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 4257398 A
- US 2005286222 A1
- US 2004100773 A1
- US 4222373 A
- DE 102004030675 A1
- US 20040256092 A1
- US 20020000311 A1
- DE 10233736 B3